# EUROPEAN PATENT SPECIFICATION

(11) **EP 4 658 010 B1**
(45) Date of publication and mention of the grant of the patent: **09.12.2026**
(21) Application number: 25174924.8
(22) Date of filing: 08.05.2025
(51) Int. Cl.: H05K 9/00, A01G 20/47, B25F 5/02

(54) **POWER TOOL AND AIRFLOW DEVICE**
ELEKTROWERKZEUG UND LUFTSTROMVORRICHTUNG
OUTIL ÉLECTRIQUE ET DISPOSITIF D'ÉCOULEMENT D'AIR

(30) Priority: 31.05.2024 CN 202410704975
(43) Date of publication of application: 03.12.2025
(73) Proprietor: Nanjing Chervon Industry Co., Ltd., Nanjing, Jiangsu 211106 (CN)
(72) Inventor: FENG, Jifeng, Nanjing, Jiangsu 211106 (CN); LI, Haiyan, Nanjing, Jiangsu 211106 (CN); GUO, Jianpeng, Nanjing, Jiangsu 211106 (CN)
(74) Representative: Sun, Yiming

(56) References cited:
- EP-A2- 1 479 334

## Description

### TECHNICAL FIELD

The present application relates to a power tool and an airflow device.

### BACKGROUND

Power tools in the related art include airflow devices such as a blower and a blower vacuum, grinding tools such as a sander and a polisher, and garden cutting tools such as a mower and a grass trimmer. The power tools are prone to generate static electricity due to friction during operation.

For example, the blower vacuum in the existing art sucks leaves etc. into a tube through the rotation of internal fan blades and collects the leaves through the tube into a leaf collection bag of the blower vacuum. During rotation, the fan blades rub against the leaves etc. and generate the static electricity. When static charges accumulate to a certain level, an electronic component is easy to break down, causing system damage, an abnormal display function, or the breakdown of a control board, which renders a failure to operate.

This part provides background information related to the present application, and the background information is not necessarily the existing art.

An example of the existing art is the document EP 1 479 334 which pertains to a suction unit for use in an electric vacuum cleaner and an electric vacuum cleaner that includes a floor nozzle and a mini nozzle detachably secured to the floor nozzle. When a suction head of the mini nozzle is secured to the floor nozzle, an air communication is provided therebetween. Further, the mini nozzle is provided with an ion generating unit. In this suction unit the friction occurs between the two bristle members, hence, the primary triboelectric charging takes place between the two different materials, not between the bristles and the surface to be cleaned. As the result, charges are being emitted outward. Specifically, the negatively charged bristle member emits negative ions to the surface to be cleaned.

### SUMMARY

A power tool according to claim 1 is disclosed.

In an example, an interval between the first material and the second material in the electrostatic sequence is greater than or equal to 2.

In an example, the friction portion includes at least a first friction portion and a second friction portion, the first friction portion is made of the first material and/or the second material, and the second friction portion is made of the first material and/or the second material.

In an example, the second friction portion is disposed in the first friction portion, and the working object is located in the first friction portion.

In an example, the first friction portion and the second friction portion are integrally formed.

In an example, the first friction portion loses electrons after rubbing against the working object, and the second friction portion gains electrons after rubbing against the working object.

In an example, the first friction portion gains electrons after rubbing against the working object, and the second friction portion loses electrons after rubbing against the working object.

In an example, the first material includes at least one of nylon, glass fiber, steel, and aluminum; and the second material includes at least one of polyethylene, polyester, and perfluoroalkoxy alkane (PFA).

In an example, the second material includes at least one of nylon, glass fiber, steel, and aluminum; and the first material includes at least one of polyethylene, polyester, and PFA.

In an example, during operation of the power tool, a voltage at a location of a smallest electrostatic charge on the friction portion 12 is less than or equal to 7 kV.

An airflow device includes a tool body. The tool body includes a duct assembly; and fan blades disposed in the duct assembly. The duct assembly includes at least a duct. An accommodation section of the duct for accommodating the fan blades and the fan blades are made of materials with different electrostatic properties.

In an example, the length of the accommodation section in an extension direction of the duct is basically consistent with the length of the fan blades in the extension direction of the duct.

In an example, the accommodation section is made of a first material and a second material with different electrostatic properties.

In an example, the fan blades are made of a third material and a fourth material with different electrostatic properties.

In an example, an interval between the materials of the accommodation section and the fan blades in an electrostatic sequence is greater than or equal to 2.

In an example, during operation of the airflow device, a voltage at a location of a smallest electrostatic charge on the friction portion 12 is less than or equal to 7 kV.

In an example, the tool body further includes an electric motor for driving the fan blades. The tool body has a working rotational speed at which the tool body is capable of operating normally. At the working rotational speed, the rotational speed of the electric motor is greater than or equal to 3000 rpm.

An airflow device includes a tool body. The tool body includes a duct assembly; and fan blades disposed in the duct assembly. The duct assembly includes at least a duct. A portion of the duct with a smallest cross section and the fan blades are made of materials with different electrostatic properties.

A power tool includes a tool body. The tool body includes a friction portion capable of rubbing against a working object to generate static electricity during operation of the power tool. The tool body further includes a friction coating disposed at a position of the friction portion capable of rubbing against the working object to generate the static electricity. The friction coating is made of at least two materials with different electrostatic properties.

In an example, the thickness of the friction coating is less than or equal to 1 mm.

In an example, the friction coating includes at least a first friction coating and a second friction coating, the first friction coating is made of a first material and/or a second material, and the second friction coating is made of the first material and/or the second material.

In an example, the first material includes at least one of nylon, glass fiber, steel, and aluminum; and the second material includes at least one of polyethylene, polyester, and PFA.

In an example, the second material includes at least one of nylon, glass fiber, steel, and aluminum; and the first material includes at least one of polyethylene, polyester, and PFA.

A power tool includes a tool body. The tool body includes a friction portion capable of rubbing against a working object to generate static electricity during operation of the power tool. The tool body further includes a friction coating disposed at a position of the friction portion capable of rubbing against the working object to generate the static electricity. The friction portion includes at least a first friction portion and a second friction portion. A first friction coating is disposed on the first friction portion, and a second friction coating is disposed on the second friction portion.

The first friction coating is made of a first material, and the second friction coating is made of a second material, where the first material and the second material have different electrostatic properties.

### BRIEF DESCRIPTION OF DRAWINGS

FIG. 1 is a perspective view of a blower as a power tool.
FIG. 2 is a sectional view of a duct assembly of a blower according to an example.
FIG. 3 is a schematic diagram of an electrostatic sequence.
FIG. 4 is a partial sectional view of a duct of a blower according to an example.
FIG. 5 is a perspective view of a blower used in experimental groups.

### DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" " and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

The present application relates to a power tool. The power tool may be a tool where an electric motor is driven to move by electrical energy, and the electric motor provides direct output or drives an output portion to output power. The power tool may be an airflow device 200 that does work through blowing or sucking, such as a blower 100, a blower vacuum, or a vacuum cleaner; a tool that rotates relative to a workpiece, such as an electric drill, an impact wrench, or an impact screwdriver; a cutting tool that linearly rubs against a workpiece, such as a circular saw, a reciprocating saw, or a table saw; a grinding tool such as a sander, a belt sander, or a polisher; or a garden tool such as a mower or a grass trimmer. It is to be noted that all technical solutions described in the present application are possibly applied to different airflow devices such as a blower vacuum working in a blowing mode or a sucking mode, a type of the "airflow device" mentioned in the present application is not limited, and any device that does work through the flow of air may be referred to as the "airflow device". The power tool involved in the present application is not limited to those of the preceding types.

When the power tool does work, the power tool often moves relative to the environment or the workpiece, thereby generating static electricity due to friction. For example, when a blower 100 blows air, dust and grass clippings in the air rub against a housing 110 of the blower. When a hand of a user touches the blower 100, the hand of the user may get an electrostatic shock, affecting the user experience. For example, when the electric drill drills into wood, a drill bit rubs against the wood and static electricity may be generated.

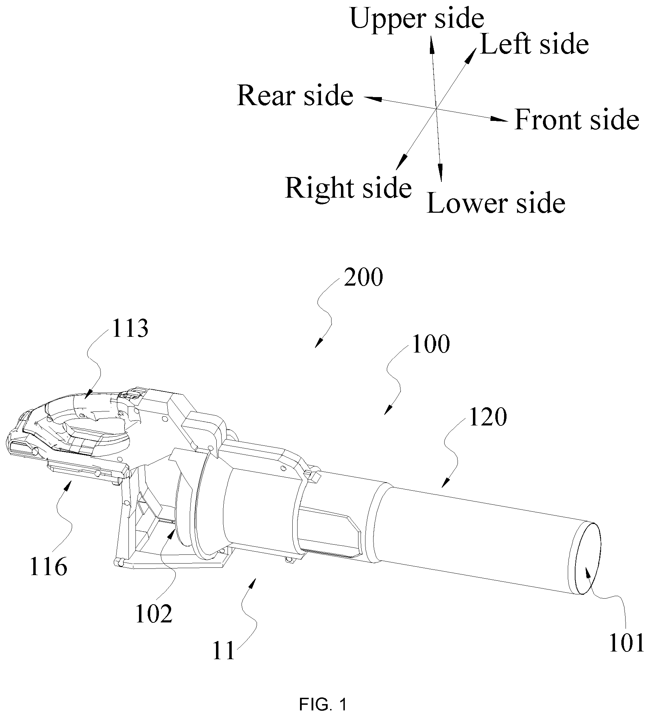

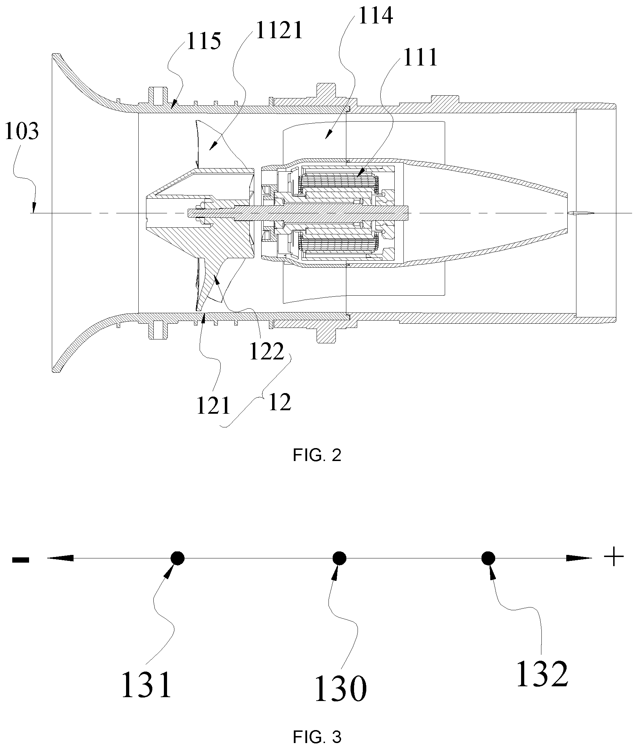

As shown in FIGS. 1 and 2, the power tool includes a tool body 11 which is a mechanism of the power tool for implementing its main function. The tool body 11 may include an electric motor 111, an output portion 112, and a grip 113. A motor shaft of the electric motor 111 of the power tool may directly output power to do work, or the electric motor 111 may drive the output portion 112 to move to do work. The grip 113 is held by the user. The tool body 11 includes a friction portion 12 capable of rubbing against a working object to generate static electricity during operation of the power tool. The working object refers to an external substance that does not belong to the power tool. For example, when the power tool is the electric drill, the working object is the wood drilled by the electric drill; and when the power tool is the blower 100, the working object is dust, wood chips, etc. in a duct. The friction portion 12 is made of at least a first material 131 and a second material 132 which are two different materials.

With the blower 100 as an example, the tool body 11 of the blower 100 includes a duct assembly 120 and the grip 113 for the user to hold, and an airflow is sucked into the blower 100 from one end of the duct assembly 120 and then flows out of the blower 100 from the other end of the duct assembly. The duct assembly 120 includes fan blades 1121, the electric motor 111, a flow guide portion 114, and a duct 115. The fan blades 1121, the electric motor 111, and the flow guide portion 114 are arranged in sequence in the duct 115, and the electric motor 111 drives the fan blades 1121 to rotate. The airflow flows in from an air inlet 102, sequentially passes through the rotating fan blades 1121 and electric motor 111 and through the flow guide portion 114 for a flow direction to be adjusted, and flows out from an air outlet 101. The duct 115 extends along a direction of a first straight line 103, a motor axis of the electric motor 111 is collinear with the first straight line 103, and the fan blades 1121 rotate around the first straight line 103. The output portion 112 of the blower 100 is the fan blades 1121, the fan blades 1121 are driven by the electric motor 111 to rotate, and an accelerated airflow is generated due to the rotation of the fan blades 1121 and flows out from the air outlet 101. The blower 100 further includes a battery pack coupling portion 116 for connecting a battery pack for powering the blower 100. Alternatively, the blower 100 may be powered by mains electricity, gasoline, or diesel or in another manner. The tool body 11 excludes accessories of the blower 100, such as a strap or a waist belt.

As shown in FIG. 3, the concept of an electrostatic sequence is introduced, where a sequence in which various substances are arranged one after another according to the polarity of static electricity generated between two substances in contact with each other is referred to as the electrostatic sequence. According to the electrostatic sequence, when two substances come into contact, the former is positively charged and the latter is negatively charged. That is to say, when objects of different substances rub against each other, it is certain that one object is positively charged and the other object is negatively charged. The electrostatic sequence refers to a sequence in which substances are sorted in an order from being positively charged to being negatively charged in terms of positive and negative charges.

The first material 131, the second material 132, and the working object 130 are sorted according to electrostatic properties to form the electrostatic sequence. In the electrostatic sequence, the working object 130 is located between the first material 131 and the second material 132. That is to say, a position of the first material 131 in the electrostatic sequence is located at one end of a position of the working object 130 in the electrostatic sequence, and a position of the second material 132 in the electrostatic sequence is located at the other end of the position of the working object 130 in the electrostatic sequence. In one example, an interval between the first material 131 and the second material 132 in the electrostatic sequence is greater than or equal to 2.

As shown in FIG. 2, the friction portion 12 includes at least a first friction portion 121 and a second friction portion 122, the first friction portion 121 is made of the first material 131 and/or the second material 132, and the second friction portion 122 is made of the first material 131 and/or the second material 132. That is to say, the power tool has the first friction portion 121 and the second friction portion 122, and at least one of the first friction portion 121 and the second friction portion 122 is made of the first material 131 and/or the second material 132.

In an example, the first friction portion 121 loses electrons after rubbing against the working object so that the first friction portion 121 is positively charged. The second friction portion 122 gains electrons after rubbing against the working object so that the second friction portion 122 is negatively charged. The positive and negative charges between the first friction portion 121 and the second friction portion 122 flow towards each other with the working object as a carrier, thereby eliminating the static electricity. In this manner, the static electricity can be eliminated by the materials of the power tool, thereby improving the user experience and preventing an element in the power tool from being damaged by the static electricity.

In an example, the first friction portion 121 gains electrons after rubbing against the working object so that the first friction portion 121 is negatively charged. The second friction portion 122 loses electrons after rubbing against the working object so that the second friction portion 122 is positively charged.

In an example, the second friction portion 122 is disposed in the first friction portion 121, and the working object is located in the first friction portion 121. Since the working object is filled between the first friction portion 121 and the second friction portion 122, the electrostatic charges generated due to friction between the working object and the tool body 11 flow between the first friction portion 121 and the second friction portion 122 to form a charge balance so that the static electricity generated due to friction is balanced inside the power tool. In the blower 100, the first friction portion 121 is an inner wall of the duct 115, the second friction portion 122 is the fan blades 1121, and the fan blades 1121 are disposed in the duct 115. When the blower 100 is in operation, the working object such as dust and wood chips is located in the duct 115. The fan blades 1121 and the duct 115 are made of the first material 131 and the second material 132 respectively, and the static electricity generated due to friction with the working object in the duct 115 flows between the fan blades 1121 and the duct 115.

In an example, the first friction portion 121 is made of the first material 131 and the second material 132, and the second friction portion 122 is also made of the first material 131 and the second material 132. In this manner, the electrostatic charges generated by the first friction portion 121 after rubbing against the working object may be neutralized on the body of the first friction portion 121, and the electrostatic charges generated by the second friction portion 122 after rubbing against the working object may also be neutralized on the body of the second friction portion 122.

In an example, the first friction portion 121 is made of the first material 131 and the second material 132, and the second friction portion 122 is made of a third material and a fourth material. The first material, the second material, the third material, and the fourth material are different from each other. In the electrostatic sequence, the working object is located between the third material and the fourth material. Thus, when the static electricity is generated during operation of the blower 100, the body of the first friction portion 121 can achieve the balance of electrostatic charges, and the body of the second friction portion 122 can also achieve the balance of electrostatic charges.

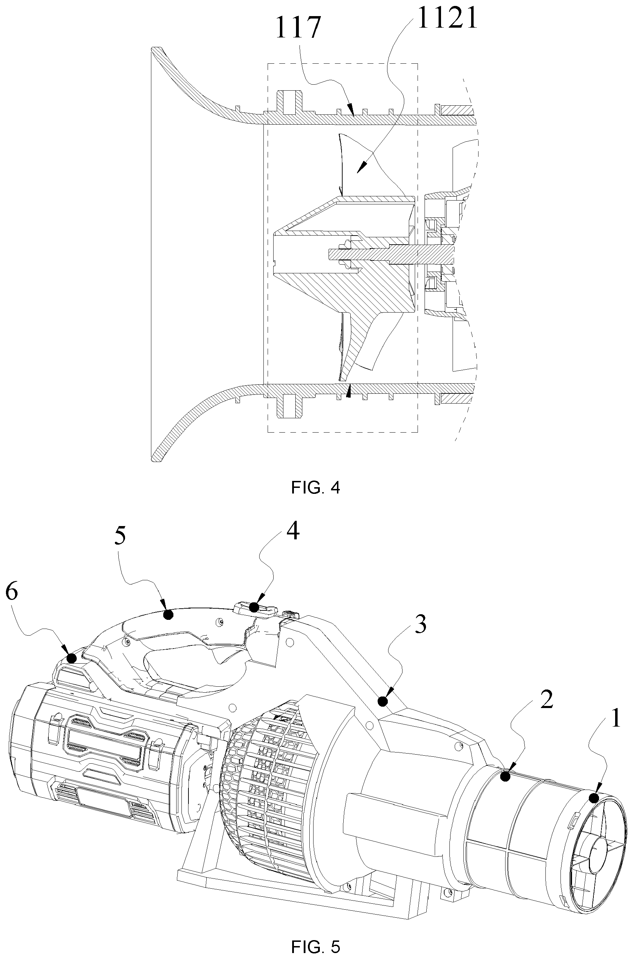

As shown in FIG. 4, the duct 115 is formed with an accommodation section 117 for accommodating the fan blades 1121, and the accommodation section 117 for accommodating the fan blades 1121 and the fan blades 1121 are made of materials with different electrostatic properties. It is to be noted that the accommodation section 117 here refers to a housing portion of the duct 115 surrounding the periphery of the fan blades 1121 along the direction of the first straight line 103. The length of the accommodation section 117 in the extension direction of the duct 115 is basically consistent with the length of the fan blades in the extension direction of the duct. In an example, the accommodation section 117 is made of the first material and the second material with different electrostatic properties. The fan blades are made of the third material and the fourth material with different electrostatic properties. An interval between the materials of the accommodation section 117 and the fan blades 1121 in the electrostatic sequence is greater than or equal to 2.

In an example, a portion of the duct 115 with a smallest cross section and the fan blades 1121 are made of materials with different electrostatic properties. The smallest cross section here refers to a smallest cross section of the inner wall of the duct 115.

During operation of the power tool, a voltage at a location of a smallest electrostatic charge on the friction portion 12 is less than or equal to 7 kV. The power tool or the blower 100 has one working gear in which the power tool or the blower 100 can operate. In the working gear, the rotational speed of the electric motor 111 is greater than or equal to 3000 rpm.

In an example, the electric drill (not shown) includes the drill bit and a housing connected to the drill bit, the drill bit has the first friction portion 121 and the second friction portion 122, and the first friction portion 121 and the second friction portion 122 are integrally formed. In this manner, when the static electricity is generated due to friction between the drill bit and the working object (such as the wood), the static electricity flows between the first friction portion 121 and the second friction portion 122 so that the positive and negative charges are offset by each other.

In an example, the friction portion 12 includes a friction coating, the friction coating is disposed at a position of the friction portion 12 capable of rubbing against the working object 130 to generate the static electricity, and the friction coating is made of at least two materials with different electrostatic properties. In an example, the thickness of the friction coating is less than or equal to 1.5 mm. In an example, the thickness of the friction coating is less than or equal to 1 mm. In an example, the thickness of the friction coating is less than or equal to 70 µm. In an example, the thickness of the friction coating is greater than or equal to 20 µm and less than or equal to 50 µm. The friction coating includes at least a first friction coating and a second friction coating, the first friction coating is made of the first material and/or the second material, and the second friction coating is made of the first material and/or the second material, where the first material and the second material have different electrostatic properties.

In an example, the friction portion 12 includes at least the first friction portion and the second friction portion, the first friction coating is disposed on the first friction portion, and the second friction coating is disposed on the second friction portion. The first friction coating is made of the first material and the second friction coating is made of the second material, where the first material and the second material have different electrostatic properties.

In all the examples involved in the present application, the first material and the second material may be selected from the materials below. In an example, the first material includes at least one of nylon, glass fiber, steel, and aluminum; and the second material includes at least one of polyethylene, polyester, and PFA. In another example, the second material includes at least one of nylon, glass fiber, steel, and aluminum; and the first material includes at least one of polyethylene, polyester, and PFA.

The applicant conducts experiments to verify the effect of the technical solutions involved in the present application. The experimental process and results are described in detail below. The charges of an object are generally measured by parameters including a quantity of electrostatic charge and an electrostatic voltage. Since the electrostatic voltage is relatively easy to measure on many occasions, the applicant reflects the quantity of electrostatic charge by the measured electrostatic voltage.

The applicant conducts control experiments by using two blowers with identical performance. In the experiments, prototype 1 does not use the solutions for eliminating the static electricity involved in the present application and prototype 2 uses the solutions for eliminating the static electricity involved in the present application. In the following table, voltage values of prototype 1 and prototype 2 are measured at the same temperature and humidity. Specifically, the experiments are conducted at a temperature of about -10 °C and a humidity of about 50%. It is to be noted that the electrostatic properties of the materials are not affected by the temperature, and the static electricity is easier to detect in a low-temperature and dry environment.

Specific positions of measurement point 1 to measurement point 6 are shown in FIG. 5. Measurement point 1 and measurement point 2 are located on the duct 115, and measurement point 1 is located before measurement point 2. Measurement point 3 is located at a housing connection between the duct 115 and the grip 113. Measurement point 4 is located on a speed regulation button of the blower. When the speed regulation button is pressed, the rotational speed of the blower may be rapidly adjusted to a maximum rotational speed. Measurement point 5 is located at the midpoint of the grip 113. Measurement point 6 is located at a rear-facing housing of the battery pack coupling portion 116.

Table 1 shows the voltage values of prototype 1 monitored at measurement point 1 to measurement point 6. Experiments No. 1 to No. 3 are conducted under the working condition of no dust during startup, that is, substances for simulating the working object 130, such as dust, are not put into the experimental environment in the experiments. Experiments No. 4 to No. 6 are conducted under the working condition of dust during startup, where dust is uniformly sprayed into the environment through a particular dust injector to simulate the presence of the working object 130 in the working environment. It can be seen that when prototype 1 that does not use the solutions for eliminating the static electricity is used in the dust environment rather than the dust-free environment, the voltages at the same measurement points significantly increase. That is to say, under an actual working condition, after the blower that does not use the solutions for eliminating the static electricity operates for a period of time, the static electricity generated due to friction with dust, wood chips, etc. is significantly increased.

Table 2 shows the voltage values of prototype 2 monitored at measurement point 1 to measurement point 6. Experiments No. 1 to No. 3 are conducted under the working condition of no dust during startup, that is, the substances for simulating the working object 130, such as dust, are not put into the experimental environment in the experiments. Experiments No. 4 to No. 6 are conducted under the working condition of dust during startup, where dust is uniformly sprayed into the environment through the particular dust injector to simulate the presence of the working object 130 in the working environment. It can be seen that when prototype 2 that uses the solutions for eliminating the static electricity is used in the dust environment rather than the dust-free environment, the voltages at the same measurement points significantly decrease. That is to say, under the actual working condition, after the blower that uses the solutions for eliminating the static electricity operates for a period of time, the static electricity generated due to friction with dust, wood chips, etc. is significantly decreased.

**Table 1**

| Experimen t No. | Measuremen t Point 1 | Measuremen t Point 2 | Measuremen t Point 3 | Measuremen t Point 4 | Measuremen t Point 5 | Measuremen t Point 6 |
|---|---|---|---|---|---|---|
| 1 | 4.1 kV | 4.9 kV | 5.1 kV | 2.8 kV | 3.5 kV | 3.2 kV |
| 2 | 4.5 kV | 3.3 kV | 3.5 kV | 3.1 kV | 4.2 kV | 3.5 kV |
| 3 | 5.4 kV | 4.2 kV | 2.8 kV | 3.2 kV | 4.3 kV | 4.2 kV |
| 4 | 21.4 kV | 23.2 kV | 16.3 kV | 8.4 kV | 19.8 kV | 17.6 kV |
| 5 | 14.9 kV | 24.3 kV | 14.8 kV | 11.4 kV | 11.4 kV | 17.6 kV |
| 6 | 13.1 kV | 18.7 kV | 7.1 kV | 6.3 kV | 9.6 kV | 18.6 kV |

**Table 2**

| Experimen t No. | Measuremen t Point 1 | Measuremen t Point 2 | Measuremen t Point 3 | Measuremen t Point 4 | Measuremen t Point 5 | Measuremen t Point 6 |
|---|---|---|---|---|---|---|
| 1 | 21.4 kV | 23.2 kV | 16.3 kV | 8.4 kV | 19.8 kV | 17.6 kV |
| 2 | 14.9 kV | 24.3 kV | 14.8 kV | 11.4 kV | 11.4 kV | 17.6 kV |
| 3 | 13.1 kV | 18.7 kV | 7.1 kV | 6.3 kV | 9.6 kV | 18.6 kV |
| 4 | 1.3 kV | 2.1 kV | 5.8 kV | 4.7 kV | 3.0 kV | 3.6 kV |
| 5 | 1.5 kV | 3.2 kV | 8.8 kV | 5.8 kV | 7.0 kV | 8.6 kV |
| 6 | 1.5 kV | 2.7 kV | 8.9 kV | 5.5 kV | 8.2 kV | 13.4 kV |

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

## Claims

1. A power tool, comprising:
a tool body (11);
wherein the tool body (11) comprises:
a friction portion (12) rubbing against a working object, thereby generating static electricity during operation of the power tool, the working object being a substance external to the power tool;
the friction portion (12) is made of at least a first material (131) and a second material (132);
a position of the first material (131) in an electrostatic sequence is located at one end of a position of the working object in the electrostatic sequence; and
a position of the second material (132) in the electrostatic sequence is located at another end of the position of the working object in the electrostatic sequence;
wherein during operation, the first material (121) and the second material (132) respectively gain or lose electrons by rubbing against the working object to carry opposite charges, such that the opposite charges flow towards each other with the working object as a carrier to eliminate the static electricity.

2. The power tool according to claim 1, wherein an interval between the first material (131) and the second material (132) in the electrostatic sequence is greater than or equal to 2.

3. The power tool according to claim 1, wherein the friction portion (12) comprises at least a first friction portion (121) and a second friction portion (122), the first friction portion (121) is made of the first material (131) and/or the second material (132), and the second friction portion (122) is made of the first material (131) and/or the second material (132).

4. The power tool according to claim 3, wherein the second friction portion (122) is disposed in the first friction portion (121), and the working object is located in the first friction portion (121).

5. The power tool according to claim 3, wherein the first friction portion (121) and the second friction portion (122) are integrally formed.

6. The power tool according to claim 3, wherein the first friction portion (121) loses electrons after rubbing against the working object, and the second friction portion (122) gains electrons after rubbing against the working object.

7. The power tool according to claim 3, wherein the first friction portion (121) gains electrons after rubbing against the working object, and the second friction portion (122) loses electrons after rubbing against the working object.

8. The power tool according to claim 1, wherein the first material (131) comprises at least one of nylon, glass fiber, steel, and aluminum; and the second material (132) comprises at least one of polyethylene, polyester, and perfluoroalkoxy alkane (PFA).

9. The power tool according to claim 1, wherein the second material (132) comprises at least one of nylon, glass fiber, steel, and aluminum; and the first material comprises (131) at least one of polyethylene, polyester, and PFA.

10. The power tool according to claim 3, wherein during operation of the power tool, a voltage at a location of a smallest electrostatic charge on the friction portion (12) is less than or equal to 7 kV.

11. The power tool according to claim 1, wherein the tool body (11) further comprises a friction coating disposed at a position of the friction portion capable of rubbing against the working object to generate the static electricity, and the friction coating is made of at least two materials with different electrostatic properties.

12. The power tool according to claim 11, wherein a thickness of the friction coating is less than or equal to 1 mm.

13. The power tool according to claim 11, wherein the friction coating comprises at least a first friction coating and a second friction coating, the first friction coating is made of the first material (131) and/or the second material (132), and the second friction coating is made of the first material (131) and/or the second material (132).

14. The power tool according to claim 13, wherein the first material (131) comprises at least one of nylon, glass fiber, steel, and aluminum; and the second material (132) comprises at least one of polyethylene, polyester, and PFA.

15. The power tool according to claim 13, wherein the second material (132) comprises at least one of nylon, glass fiber, steel, and aluminum; and the first material (131) comprises at least one of polyethylene, polyester, and PFA.

## Patentansprüche

1. Kraftbetriebenes Werkzeug, umfassend:
einen Werkzeugkörper (11);
wobei der Werkzeugkörper (11) Folgendes umfasst:
einen Reibungsabschnitt (12), der an einem Arbeitsobjekt reibt und dadurch während des Betriebs des kraftbetriebenen Werkzeugs statische Elektrizität erzeugt, wobei das Arbeitsobjekt eine Substanz außerhalb des kraftbetriebenen Werkzeugs ist;
wobei der Reibungsabschnitt (12) aus mindestens einem ersten Material (131) und einem zweiten Material (132) hergestellt ist;
eine Position des ersten Materials (131) in einer elektrostatischen Reihe auf einer Seite einer Position des Arbeitsobjekts in der elektrostatischen Reihe liegt; und
eine Position des zweiten Materials (132) in der elektrostatischen Reihe auf der anderen Seite der Position des Arbeitsobjekts in der elektrostatischen Reihe liegt;
wobei während des Betriebs das erste Material (121) und das zweite Material (132) durch Reiben an dem Arbeitsobjekt jeweils Elektronen aufnehmen oder abgeben, um entgegengesetzte Ladungen zu tragen, sodass die entgegengesetzten Ladungen mit dem Arbeitsobjekt als Träger aufeinander zufließen, um die statische Elektrizität zu beseitigen.

2. Kraftbetriebenes Werkzeug nach Anspruch 1, wobei ein Abstand zwischen dem ersten Material (131) und dem zweiten Material (132) in der elektrostatischen Reihe größer als oder gleich 2 ist.

3. Kraftbetriebenes Werkzeug nach Anspruch 1, wobei der Reibungsabschnitt (12) mindestens einen ersten Reibungsabschnitt (121) und einen zweiten Reibungsabschnitt (122) umfasst, der erste Reibungsabschnitt (121) aus dem ersten Material (131) und/oder dem zweiten Material (132) hergestellt ist und der zweite Reibungsabschnitt (122) aus dem ersten Material (131) und/oder dem zweiten Material (132) hergestellt ist.

4. Kraftbetriebenes Werkzeug nach Anspruch 3, wobei der zweite Reibungsabschnitt (122) in dem ersten Reibungsabschnitt (121) angeordnet ist und sich das Arbeitsobjekt in dem ersten Reibungsabschnitt (121) befindet.

5. Kraftbetriebenes Werkzeug nach Anspruch 3, wobei der erste Reibungsabschnitt (121) und der zweite Reibungsabschnitt (122) einstückig ausgebildet sind.

6. Kraftbetriebenes Werkzeug nach Anspruch 3, wobei der erste Reibungsabschnitt (121) nach dem Reiben an dem Arbeitsobjekt Elektronen abgibt und der zweite Reibungsabschnitt (122) nach dem Reiben an dem Arbeitsobjekt Elektronen aufnimmt.

7. Kraftbetriebenes Werkzeug nach Anspruch 3, wobei der erste Reibungsabschnitt (121) nach dem Reiben an dem Arbeitsobjekt Elektronen aufnimmt und der zweite Reibungsabschnitt (122) nach dem Reiben an dem Arbeitsobjekt Elektronen abgibt.

8. Kraftbetriebenes Werkzeug nach Anspruch 1, wobei das erste Material (131) mindestens eines der Materialien Nylon, Glasfaser, Stahl und Aluminium umfasst; und das zweite Material (132) mindestens eines der Materialien Polyethylen, Polyester und Perfluoralkoxyalkan (PFA) umfasst.

9. Kraftbetriebenes Werkzeug nach Anspruch 1, wobei das zweite Material (132) mindestens eines der Materialien Nylon, Glasfaser, Stahl und Aluminium umfasst; und das erste Material (131) mindestens eines der Materialien Polyethylen, Polyester und PFA umfasst.

10. Kraftbetriebenes Werkzeug nach Anspruch 3, wobei während des Betriebs des kraftbetriebenen Werkzeugs eine Spannung an einer Stelle mit der geringsten elektrostatischen Ladung am Reibungsabschnitt (12) kleiner als oder gleich 7 kV ist.

11. Kraftbetriebenes Werkzeug nach Anspruch 1, wobei der Werkzeugkörper (11) ferner eine Reibungsbeschichtung umfasst, die an einer Stelle des Reibungsabschnitts angeordnet ist, an der durch Reiben an dem Arbeitsobjekt die statische Elektrizität erzeugt werden kann, und die Reibungsbeschichtung aus mindestens zwei Materialien mit unterschiedlichen elektrostatischen Eigenschaften hergestellt ist.

12. Kraftbetriebenes Werkzeug nach Anspruch 11, wobei eine Dicke der Reibungsbeschichtung kleiner als oder gleich 1 mm ist.

13. Kraftbetriebenes Werkzeug nach Anspruch 11, wobei die Reibungsbeschichtung mindestens eine erste Reibungsbeschichtung und eine zweite Reibungsbeschichtung umfasst, die erste Reibungsbeschichtung aus dem ersten Material (131) und/oder dem zweiten Material (132) hergestellt ist und die zweite Reibungsbeschichtung aus dem ersten Material (131) und/oder dem zweiten Material (132) hergestellt ist.

14. Kraftbetriebenes Werkzeug nach Anspruch 13, wobei das erste Material (131) mindestens eines der Materialien Nylon, Glasfaser, Stahl und Aluminium umfasst; und das zweite Material (132) mindestens eines der Materialien Polyethylen, Polyester und PFA umfasst.

15. Kraftbetriebenes Werkzeug nach Anspruch 13, wobei das zweite Material (132) mindestens eines der Materialien Nylon, Glasfaser, Stahl und Aluminium umfasst; und das erste Material (131) mindestens eines der Materialien Polyethylen, Polyester und PFA umfasst.

## Revendications

1. Outil motorisé, comprenant :
un corps d'outil (11) ;
dans lequel le corps d'outil (11) comprend :
une partie de frottement (12) frottant contre un objet de travail, produisant ainsi de l'électricité statique pendant le fonctionnement de l'outil motorisé, l'objet de travail étant une substance extérieure à l'outil motorisé ;
la partie de frottement (12) étant constituée d'au moins un premier matériau (131) et un second matériau (132) ;
une position du premier matériau (131) dans une série électrostatique se situant d'un côté d'une position de l'objet de travail dans la série électrostatique ; et
une position du second matériau (132) dans la série électrostatique se situant de l'autre côté de la position de l'objet de travail dans la série électrostatique ;
dans lequel, pendant le fonctionnement, le premier matériau (121) et le second matériau (132) acquièrent ou cèdent respectivement des électrons par frottement contre l'objet de travail pour porter des charges opposées, de sorte que les charges opposées se déplacent l'une vers l'autre avec l'objet de travail comme support afin d'éliminer l'électricité statique.

2. Outil motorisé selon la revendication 1, dans lequel un intervalle entre le premier matériau (131) et le second matériau (132) dans la série électrostatique est supérieur ou égal à 2.

3. Outil motorisé selon la revendication 1, dans lequel la partie de frottement (12) comprend au moins une première partie de frottement (121) et une seconde partie de frottement (122), la première partie de frottement (121) est constituée du premier matériau (131) et/ou du second matériau (132), et la seconde partie de frottement (122) est constituée du premier matériau (131) et/ou du second matériau (132).

4. Outil motorisé selon la revendication 3, dans lequel la seconde partie de frottement (122) est disposée dans la première partie de frottement (121), et l'objet de travail est situé dans la première partie de frottement (121).

5. Outil motorisé selon la revendication 3, dans lequel la première partie de frottement (121) et la seconde partie de frottement (122) sont formées d'un seul tenant.

6. Outil motorisé selon la revendication 3, dans lequel la première partie de frottement (121) cède des électrons après avoir frotté contre l'objet de travail, et la seconde partie de frottement (122) acquiert des électrons après avoir frotté contre l'objet de travail.

7. Outil motorisé selon la revendication 3, dans lequel la première partie de frottement (121) acquiert des électrons après avoir frotté contre l'objet de travail, et la seconde partie de frottement (122) cède des électrons après avoir frotté contre l'objet de travail.

8. Outil motorisé selon la revendication 1, dans lequel le premier matériau (131) comprend au moins un matériau parmi le nylon, la fibre de verre, l'acier et l'aluminium ; et le second matériau (132) comprend au moins un matériau parmi le polyéthylène, le polyester et le perfluoroalcoxyalcane (PFA).

9. Outil motorisé selon la revendication 1, dans lequel le second matériau (132) comprend au moins un matériau parmi le nylon, la fibre de verre, l'acier et l'aluminium ; et le premier matériau (131) comprend au moins un matériau parmi le polyéthylène, le polyester et le PFA.

10. Outil motorisé selon la revendication 3, dans lequel, pendant le fonctionnement de l'outil motorisé, une tension à un emplacement où la charge électrostatique est la plus faible sur la partie de frottement (12) est inférieure ou égale à 7 kV.

11. Outil motorisé selon la revendication 1, dans lequel le corps d'outil (11) comprend en outre un revêtement de frottement disposé à un emplacement de la partie de frottement pouvant frotter contre l'objet de travail pour produire l'électricité statique, et le revêtement de frottement est constitué d'au moins deux matériaux présentant des propriétés électrostatiques différentes.

12. Outil motorisé selon la revendication 11, dans lequel une épaisseur du revêtement de frottement est inférieure ou égale à 1 mm.

13. Outil motorisé selon la revendication 11, dans lequel le revêtement de frottement comprend au moins un premier revêtement de frottement et un second revêtement de frottement, le premier revêtement de frottement est constitué du premier matériau (131) et/ou du second matériau (132), et le second revêtement de frottement est constitué du premier matériau (131) et/ou du second matériau (132).

14. Outil motorisé selon la revendication 13, dans lequel le premier matériau (131) comprend au moins un matériau parmi le nylon, la fibre de verre, l'acier et l'aluminium ; et le second matériau (132) comprend au moins un matériau parmi le polyéthylène, le polyester et le PFA.

15. Outil motorisé selon la revendication 13, dans lequel le second matériau (132) comprend au moins un matériau parmi le nylon, la fibre de verre, l'acier et l'aluminium ; et le premier matériau (131) comprend au moins un matériau parmi le polyéthylène, le polyester et le PFA.
